# FASCICULE DE BREVET EUROPEEN

(11) **EP 0 887 861 B1**
(45) Date de publication et mention de la délivrance du brevet: **26.10.2005**
(21) Numéro de dépôt: 98401561.0
(22) Date de dépôt: 25.06.1998
(51) Int. Cl.: H01L 23/64

(54) **Dispositif semi-conducteur à moyen d'échanges à distance**
Halbleiteranordnung mit getrennten Auswechselungsmitteln
Semiconductor device having separated exchange means

(30) Priorité: 27.06.1997 FR 9708147
(43) Date de publication de la demande: 30.12.1998
(73) Titulaire: STMicroelectronics S.A., 92120 Montrouge (FR); FRANCE TELECOM, 75015 Paris (FR)
(72) Inventeur: Jaouen, Hervé, 38240 Meylan (FR); Marty, Michel, 38760 Varces (FR)
(74) Mandataire: Casalonga, Axel

(56) Documents cités:
- EP-A- 0 376 062
- WO-A-96/16378
- US-A- 5 519 582
- PATENT ABSTRACTS OF JAPAN vol. 005, no. 159 (E-077), 14 octobre 1981 & JP 56 090551 A (MITSUBISHI ELECTRIC CORP), 22 juillet 1981
- PATENT ABSTRACTS OF JAPAN vol. 097, no. 001, 31 janvier 1997 & JP 08 250913 A (HONDA MOTOR CO LTD), 27 septembre 1996

## Description

La présente invention concerne le domaine de la microélectronique et plus particulièrement un dispositif semi-conducteur qui comprend une pastille formant un circuit intégré et un substrat de connexion, dans lequel sont prévus, entre les faces juxtaposées de la pastille et du substrat, des éléments ponctuels ou billes de connexion répartis sous la forme d'une matrice et dans lequel le substrat présente des moyens de connexion extérieure reliés auxdits points de connexion.

Le dispositif semi-conducteur selon la présente invention comprend en outre au moins un moyen d'échanges comprenant deux parties disposées à distance et au regard l'une de l'autre et susceptibles d'échanger entre elles des signaux, dans un sens et/ou dans l'autre, l'une desdites parties étant intégrée dans ladite pastille et constituant un composant dudit circuit intégré et l'autre partie étant portée par ledit substrat et reliée auxdits moyens de connexion.

Selon l'invention, ledit moyen d'échanges est avantageusement disposé dans une zone exempte de points de connexion.

Selon une exécution préférée de l'invention, lesdites parties dudit moyen d'échanges comprennent des inductances à spires coplanaires disposées à distance et au regard l'une de l'autre de façon à être couplées par induction magnétique.

Selon l'invention, un isolant électrique est de préférence disposé entre lesdites inductances.

Selon une variante d'exécution, l'inductance portée par le substrat est sérigraphiée sur la surface de ce dernier adjacente à la pastille.

Selon une variante préférée de l'invention, l'inductance intégrée à la pastille est réalisée en arrière d'une dernière couche isolante, avec le dernier niveau de métallisation.

Selon l'invention, les moyens de connexion extérieure du substrat comprennent des plots ou billes de connexion extérieure répartis sous la forme d'une matrice sur sa surface opposée à la pastille

Selon l'invention, le substrat constitue de préférence une portion de la paroi d'un boîtier d'encapsulisation de la pastille.

La présente invention sera mieux comprise à l'étude d'un dispositif semi-conducteur décrit à titre d'exemple non limitatif et illustré par le dessin sur lequel :

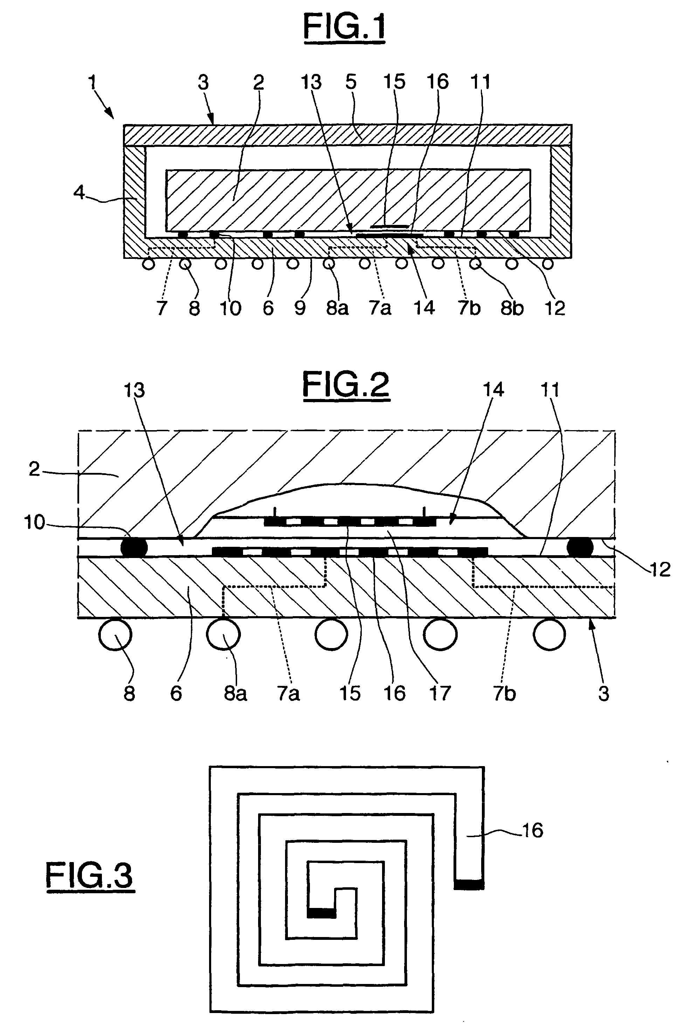

- la figure 1 représente une coupe transversale d'un dispositif semi-conducteur selon l'invention ;
- la figure 2 représente une coupe agrandie de la partie centrale du dispositif semi-conducteur de la figure 1 ;
- et la figure 3 représente une vue de dessus du substrat de la figure 1.

En se reportant aux figures, on voit qu'on a représenté un dispositif semi-conducteur repéré d'une manière générale par la référence 1 qui comprend une pastille 2 formant un circuit intégré, encapsulée dans un boîtier 3 qui comprend une cuvette 4 et un couvercle 5.

Le fond 6 de la cuvette 4 est constitué par un substrat intégrant une multiplicité de lignes de connexion 7 reliant des billes de connexion extérieures 8 déposées sur la face extérieure 9 de la paroi 6 à des billes ou points de connexion 10 interposés dans l'espace séparant la face intérieure 11 de la paroi 6 et la face avant 12 de la pastille 2, ces billes 10 étant reliées au circuit intégré dans la pastille 2.

Les billes de connexion extérieure 8 sont réparties sous la forme d'une matrice et les billes de connexion intérieure 10 sont réparties sous la forme d'une matrice laissant un espace 13 sensiblement central exempt de billes.

La densité des billes extérieures 8 est plus grande que la densité des billes 10 de manière à faciliter la connexion du boîtier par exemple à des pistes d'un circuit imprimé.

Dans la zone 13 exempte de billes, le dispositif semi-conducteur 1 comprend un moyen d'échanges de signaux 14 en deux parties dont l'une est constituée par une inductance à spires coplanaires 15 qui est intégrée à la pastille 2 et qui constitue un composant du circuit intégré dans cette pastille 2 et dont l'autre est constituée par une inductance à spires coplanaires 16 qui est réalisée par sérigraphie sur la face intérieure 11 de la paroi 6 du boîtier 3 et qui présente des extrémités reliées à deux billes 8a et 8b de la matrice extérieure de billes 8 par l'intermédiaire de lignes de connexion 7a et 7b.

De préférence, l'inductance 15 intégrée dans la pastille 2 est réalisée dans la dernière couche de composants ou de métalisation de cette dernière et se trouve ainsi située dans la position la plus éloignée du silicium. De plus, elle est recouverte d'une couche avant d'isolant 17.

Ainsi, les inductances 15 et 16 sont couplées par induction magnétique et forment un transformateur radio-fréquence qui permet de réaliser des échanges de signaux, dans un sens et/ou dans l'autre, entre le circuit intégré dans la pastille 2 et l'extérieur du boîtier 3 par les billes de connexion 8a et 8b.

Dans un exemple de réalisation non limitatif, l'inductance 15 intégrée dans la pastille 2 peut présenter un diamètre compris entre cent microns et un mm, une épaisseur comprise entre 0,4 et 2 microns, un nombre de spires compris entre 4 et 25, et une distance entre spires comprise entre 0,4 et 2 microns.

L'inductance 16 sérigraphiée sur la paroi intérieure 6 du boîtier 3 peut présenter un diamètre compris entre un et trois mm, une épaisseur comprise entre 10 et 100 microns, un nombre de spires compris entre quatre et vingt cinq, et une distance entre spires comprise entre 1 et 10 microns.

La couche d'isolant 17 de la pastille 2 peut présenter une épaisseur d'environ un micron. L'espace séparant la face avant 12 de la pastille 2 et la face intérieure 11 de la paroi 6 du boîtier 3 peut être d'environ cent microns.

Du point de vue de ses avantages, le moyen d'échanges de signaux 14 constitué par les inductances 15 et 16 ne présente aucune liaison galvanique et permet ainsi de supprimer au moins certains des circuits de protection normalement intégrés dans la pastille. Il permet en outre des entrées et/ou sorties de données à des débits très élevés.

Dans une application particulière, le moyen d'échanges de signaux 14 peut être utilisé pour des entrées/sorties de signaux radiofréquences et peut constituer le circuit d'entrée d'une antenne. Il peut avantageusement être utilisé notamment dans le domaine des appareils téléphoniques.

## Revendications

1. Dispositif semi-conducteur comprenant une pastille formant un circuit intégré et un substrat de connexion, dans lequel sont prévus, entre les faces juxtaposées de la pastille et du substrat, des éléments ponctuels ou billes de connexion répartis sous la forme d'une matrice et dans lequel le substrat présente des moyens de connexion extérieure reliés auxdits points de connexion,
**caractérisé par le fait qu'**il comprend en outre au moins un moyen d'échanges (14) comprenant deux parties (15, 16) disposées à distance et au regard l'une de l'autre et susceptibles d'échanger entre elles des signaux, dans un sens et/ou dans l'autre sans aucune liaison galvanique, l'une desdites parties étant intégrée dans ladite pastille et constituant un composant dudit circuit intégré et l'autre partie étant portée par ledit substrat (6) et reliée auxdits moyens de connexion (7).

2. Dispositif semi-conducteur selon la revendication 1, **caractérisé par le fait que** ledit moyen d'échanges est disposé dans une zone (13) exempte de points de connexion.

3. Dispositif semi-conducteur, selon l'une des revendications 1 et 2, **caractérisé par le fait que** lesdites parties dudit moyen d'échanges comprennent des inductances (15, 16) à spires coplanaires disposées à distance et au regard l'une de l'autre de façon à être couplées par induction magnétique.

4. Dispositif semi-conducteur selon la revendication 3, **caractérisé par le fait qu'**il comprend un isolant électrique (17) disposé entre lesdites inductances.

5. Dispositif semi-conducteur selon l'une des revendications 3 et 4, **caractérisé par le fait que** l'inductance portée par le substrat est sérigraphiée sur la surface de ce dernier adjacente à la pastille.

6. Dispositif semi-conducteur selon l'une quelconque des revendications 4 à 7, **caractérisé par le fait que** l'inductance intégrée à la pastille est réalisée en arrière d'une dernière couche isolante (17), avec le dernier niveau de métallisation.

7. Dispositif semi-conducteur selon l'une quelconque des revendications précédentes, **caractérisé par le fait que** les moyens de connexion du substrat comprennent des plots ou billes de connexion extérieure (8) répartis sous la forme d'une matrice sur sa surface opposée à la pastille.

8. Dispositif semi-conducteur selon l'une quelconque des revendications précédentes, **caractérisé par le fait que** le substrat (6) constitue une portion de la paroi d'un boîtier (3) d'encapsulisation de la pastille.

## Patentansprüche

1. Halbleitervorrichtung, die ein Plättchen, das einen integrierten Schaltkreis bildet, und ein Anschlusssubstrat umfasst, in dem zwischen den nebeneinander liegenden Seiten des Plättchens und des Substrats Anschlusspunkte oder -kugeln in Form einer Matrix verteilt sind, und bei der das Substrat Mittel zum äußeren Anschließen aufweist, die mit den Anschlusspunkten verbunden sind,
**dadurch gekennzeichnet, dass** sie ferner ein Mittel für Austausche (14) umfasst, das zwei Teile (15, 16) umfasst, die entfernt und einander gegenüber angeordnet sind und untereinander Signale in die eine und/oder in die andere Richtung ohne jede elektrische Verbindung austauschen können, wobei die Teile in das Plättchen eingebaut sind und einen Bauteil des integrierten Schaltkreises bilden, und wobei der andere Teil von dem Substrat (6) getragen wird und an die Verbindungsmittel (7) angeschlossen ist.

2. Halbleitervorrichtung nach Anspruch 1, **dadurch gekennzeichnet, dass** das Mittel für Austausche in einer Zone (13) angeordnet ist, die keine Anschlusspunkte enthält.

3. Halbleitervorrichtung nach einem der Ansprüche 1 und 2, **dadurch gekennzeichnet, dass** die Teile der Mittel für Austausche Induktanzen (15, 16) mit koplanaren Windungen umfassen, die entfernt und einander gegenüber so angeordnet sind, dass sie durch magnetische Induktion gekoppelt sind.

4. Halbleitervorrichtung nach Anspruch 3, **dadurch gekennzeichnet, dass** sie eine elektrische Isolation (17) umfasst, die zwischen den Induktanzen angeordnet ist.

5. Halbleitervorrichtung nach einem der Ansprüche 3 und 4, **dadurch gekennzeichnet, dass** die von dem Substrat getragene Induktanz auf die Oberfläche dieses Letzteren, die neben dem Plättchen liegt, serigraphiert ist.

6. Halbleitervorrichtung nach einem der Ansprüche 4 bis 5, **dadurch gekennzeichnet, dass** die in das Plättchen eingebaute Induktanz hinter einer letzten isolierenden Schicht (17) zu dem letzten Metallisierungsniveau hergestellt ist.

7. Halbleitervorrichtung nach einem der vorhergehenden Ansprüche, **dadurch gekennzeichnet, dass** die Anschlussmittel des Substrats äußere Anschlusskontakte oder -kugeln (8) umfassen, die in Form einer Matrix auf ihrer dem Plättchen entgegengesetzten Oberfläche verteilt sind.

8. Halbleitervorrichtung nach einem der vorhergehenden Ansprüche, **dadurch gekennzeichnet, dass** das Substrat (6) einen Teil der Wand eines Verkapselungsgehäuses (3) des Plättchens umfasst.

## Claims

1. Semiconductor device which comprises a chip forming an integrated circuit and a connection substrate, in which device connection points or balls distributed in the form of a matrix are provided between the juxtaposed faces of the chip and of the substrate and in which the substrate has external connection means connected to the said connection points,
**characterized in that** it furthermore comprises at least one exchange means (14) comprising two parts (15, 16) which are arranged so as to be separated from and facing each other and capable of exchanging signals between them, in one or both directions, without any galavanic coupling, one of the said parts being integrated into the said chip and constituting a component of the said integrated circuit and the other part being carried by the said substrate (6) and connected to the said connection means (7).

2. Semiconductor device according to Claim 1, **characterized in that** the said exchange means is placed in a region (13) having no connection points.

3. Semiconductor device according to either of Claims 1 and 2, **characterized in that** the said parts of the said exchange means comprise inductors (15, 16) having coplanar turns, the said inductors being arranged so as to be separated from and facing each other, so as to be coupled by magnetic induction.

4. Semiconductor device according to Claim 3, **characterized in that** it comprises an electrical insulator (17) arranged between the said inductors.

5. Semiconductor device according to either of Claims 3 and 4, **characterized in that** the inductor carried by the substrate is screen-printed onto that surface of the substrate which is adjacent to the chip.

6. Semiconductor device according to any one of Claims 4 to 7, **characterized in that** the inductor integrated into the chip is produced, to the rear of a final insulating layer (17), with the final level of metallization.

7. Semiconductor device according to any one of the preceding claims, **characterized in that** the connection means of the substrate comprise external connection pads or balls(8) distributed in the form of a matrix on its surface opposite the chip.

8. Semiconductor device according to any one of the preceding claims, **characterized in that** the substrate (6) constitutes a portion of the wall of a package (3) for encapsulating the chip.
